# EUROPEAN PATENT SPECIFICATION

(11) **EP 2 434 859 B1**
(45) Date of publication and mention of the grant of the patent: **06.04.2016**
(21) Application number: 10777921.7
(22) Date of filing: 17.05.2010
(51) Int. Cl.: H05K 9/00, H05K 3/30

(54) **CONDUCTIVE CONTACT TERMINAL TO BE MOUNTED ON A SUBSTRATE SURFACE**
LEITFÄHIGE KONTAKTKLEMME ZUR MONTAGE AUF EINER SUBSTRATOBERFLÄCHE
BORNE DE CONTACT CONDUCTRICE À MONTER SUR UNE SURFACE DE SUBSTRAT

(30) Priority: 18.05.2009 KR 20090043248
(43) Date of publication of application: 28.03.2012
(73) Proprietor: Doo Sung Industrial Co., Ltd., Ansan-si, Gyeonggi-do 426-180 (KR)
(72) Inventor: KIM, Seon Tae, Ansan-si Gyeonggi-do 426-815 (KR); LEE, Hyung Chun, Suwon-si Gyeonggi-do 440-300 (KR); LEE, Sang Won, Busan 614-814 (KR)
(74) Representative: Franks & Co Limited
(86) International application number: PCT/KR2010/003114
(87) International publication number: WO 2010/134734

(56) References cited:
- EP-A1- 2 099 269
- WO-A1-2009/110653
- KR-A- 20050 076 370
- KR-A- 20070 105 336
- KR-A- 20100 125 617
- KR-A- 20110 020 034
- KR-B1- 100 762 854
- KR-B1- 100 783 588
- KR-B1- 100 783 588
- KR-B1- 100 892 720
- KR-Y1- 200 394 223
- US-A1- 2006 103 081

## Description

### [Technical Field]

The present invention relates to a conductive contact terminal for surface mounting on a substrate, and more particularly, to a conductive contact terminal that can be used in the contact area between a circuit board and an electronic component or in the contact area between two or more electronic components in the process of placing the electronic components on a circuit board.

### [Background Art]

In the electronic and telecommunication industries, demands for technologies that reduce processing costs and miniaturize products are considered important, and therefore, complicated electronic circuits and densely-populated integrated circuits are being mass-produced. Surface-Mount Technology (SMT) is automation technology in which electronic components are attached to a Printed Circuit Board (PCB) by directly mounting the components on the PCB. The SMT process has enabled further improvement of the quality of electrical contact between electronic components, reduction in processing times, and the miniaturization of products.

A conductive contact terminal may be interposed between an electronic component and a circuit board in order to bond the electronic component to the circuit board. In general, the height of the bonding section varies depending on the circuit. Thus, in some cases, such conductive contact terminals are applied after they are adapted to the height of the bonding section, or elastic contact terminals made of metal are used. In addition, it is required to interpose an elastic conductive contact terminal between such bonding areas in order to prevent the problem of defective electrical connections due to the unevenness of the bonding surface or the difference in bonding sizes.

The SMT process, which includes reflow soldering, is carried out at a high temperature ranging from 180°C to 270°C. When a typical conductive material is simply used, the product is deformed, and thus loses conductivity. Consequently, in practice, the product cannot function as a conductive contact terminal, and it is therefore required to use a contact terminal that is suitable for the SMT process. Accordingly, in the related art, a conductive contact terminal, which is made of an elastically resilient metal such as a Be-Cu alloy, is used in order to prevent the contact terminal from being thermally deformed. However, even the Be-Cu alloy has limited elasticity, and thus there is a problem in that it is difficult to apply the Be-Cu alloy when the portion that will be electrically connected is high.

Korean Registered Utility Model No. 390490 discloses a surface-mounting electrical contact terminal, which includes a nonconductive elastic rubber, a coating layer made of a conductive elastic rubber and a metal film, the coating layer and the metal film covering the nonconductive elastic rubber. In this case, there are problems in that current leakage occurs due to the relatively high resistance of the conductive elastic rubber, and in that conductivity is lost in the event that the conductive coating layer is damaged.

Korean Patent Nos. 0783588 and 839893 disclose electrical contact terminals, which are regarded as useful for electrical contact terminals that have a predetermined size or more, since their elasticity is provided by the foaming of the elastic rubber or pores in the elastic rubber. Specifically, the use of a foamed elastic rubber or a tubular elastic rubber having pores according to the above patents leads to drawbacks in that it is difficult to fabricate a small elastic electrical contact terminal that is 2.2mm high or less and narrow, and in that costs are increased. Furthermore, since the use of vacuum pickup in automatic reflow soldering involves a large motion, there is the problem of poor yield.

Referring to FIG. 1, Korean Patent No. 892720 discloses an elastic electrical contact terminal. This contact terminal includes an elastic core 100, which consists of an insulating unfoamed elastic rubber and an unfoamed rubber coating layer, and a metal layer 200, which is coupled to the elastic core 100 via a nonconductive bonding layer 300. The metal layer is formed by sputtering a metal on a heat-resistant polymer film, followed by plating a metal on the metal-sputtered film.

However, when the electrical contact terminal is repeatedly subjected to expansion and contraction several times due to pressure applied thereto, the metal layer 200 may be broken under compressive stress that exceeds its own compressive strength. When the metal layer of the electrical contact terminal described above is broken, the conductivity of the entire electrical contact terminal is destroyed, since the polymer film inside the metal layer is nonconductive. This causes a problem in that the electrical contact terminal cannot function as an electrical contact terminal.

### [Disclosure]

### [Technical Problem]

In order to solve the foregoing problems with the prior art, the present invention is intended to provide a conductive contact terminal for surface mounting, which has a low electrical resistance, does not exhibit a deformation in the material even in a high-temperature reflow soldering process, and does not lose conductivity even though a metal layer, which imparts electrical conductivity to the conductive contact terminal, is broken.

### [Technical Solution]

In order to realize the foregoing object, the conductive contact terminal for surface mounting of the present invention includes an elastic core (10), which imparts elasticity to the contact terminal; a metal layer (20), which covers the outer portion of the elastic core; and characterized by a conductive adhesive layer (30), which is interposed between the elastic core and the metal layer to bond the elastic core and the metal layer to each other wherein the metal layer comprises:
a film layer (21); and first and second metal coating layers (22), each of the first and second metal coating layers being applied on a corresponding one of opposite surfaces of the film layer, wherein the film layer has a plurality of holes therein, and the first and second metal coating layers are electrically connected to each other through walls of the holes in the film layer.

### [Advantageous Effects]

The conductive contact terminal for surface mounting on a substrate according to the present invention is suitable for a reflow soldering process, since it neither deforms nor loses conductivity at high temperatures. In addition, since the conductive contact terminal has a very low electrical resistance, the possibility of power loss due to the electrical resistance of the contact terminal is very low.

Furthermore, the conductive contact terminal for surface mounting on a substrate can be used by being inserted into portions having a variety of heights, which are required for the portions into which the conductive contact terminal is intended to be inserted, since it has a sufficient degree of elasticity, unlike the contact terminal of the related art, which is made only of metal.

In addition, in the conductive contact terminal of the present invention, the opposite ends in the lengthwise direction of the conductive elastic core are exposed, such that the elastic core can easily escape through the opposite ends when pressure is applied thereto, thereby providing reliable elasticity and resiliency.

Furthermore, in the conductive contact terminal for surface mounting of the present invention which employs the electrically conductive adhesive and the electrically conductive elastic core or the electrically conductive adhesive and the electrically nonconductive elastic core, the electrically conductive adhesive and the electrically conductive elastic core impart the conductive contact terminal with the function of remaining conductive even when the metal layer is broken due to repeated expansion and contraction caused by external pressure. That is, even in the event that the metal layer is broken, electrical conductivity can be maintained since the conductive adhesive and the conductive elastic core inside the metal layer are conductive.

Considering that the metal layer is frequently broken due to pressure being repeatedly applied to the conductive contact terminal and the elasticity of the metal being inferior to that of the elastic core, and that the contact terminal therefore frequently loses conductivity, the function of retaining conductivity can increase the stability and longevity of the conductive contact terminal.

### [Description of Drawings]

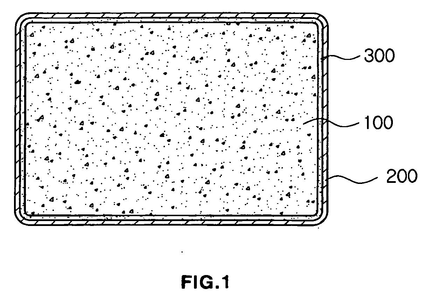

FIG. 1 is a cross-sectional view showing a contact terminal of the related art, which is fabricated using a nonconductive elastic core and a nonconductive adhesive layer;
FIG. 2 is a perspective view showing a conductive contact terminal for surface mounting on a substrate according to an embodiment of the present invention;
FIG. 3 is a perspective view showing a conductive contact terminal for surface mounting on a substrate according to another embodiment of the present invention;
FIG. 4 is a perspective view showing a conductive contact terminal for surface mounting on a substrate according to a further embodiment of the present invention; and
FIG. 5 is a perspective view showing a conductive contact terminal for surface mounting on a substrate according to yet another embodiment of the present invention.

### <Major Reference Numerals of the Drawings>

| | | | |
|---|---|---|---|
| 10: | elastic core | 20: | conductive metal layer |
| 21: | heat resistant film | 22: | metal coating layer |
| 30: | adhesive layer | 40: | metal film |
| 50: | center hole | | |

### [Best Mode]

A conductive contact terminal for surface mounting on a substrate according to the present invention includes a structure that is configured such that an elastic core is covered with a metal layer that can be soldered.

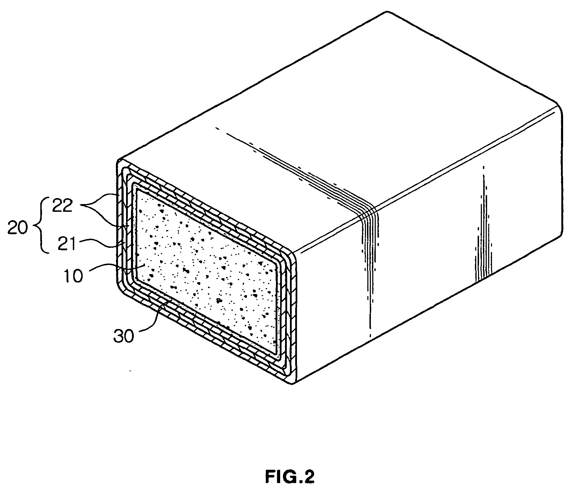

Hereinafter, the conductive contact terminal for surface mounting on a substrate according to the present invention will be described in detail with reference to FIG. 2.

A primary component of the conductive contact terminal 1 of the present invention is an elastic core 10, i.e. a core material that provides elastic force. The elastic core imparts the contact terminal of the present invention with elasticity. It is preferred that the elastic core be made of silicone rubber, bridged natural rubber or bridged synthetic rubber. Considering that surface mounting is performed at a temperature ranging from 180 to 270°C, it is preferred that the elastic core be made of a heat resistant material, so that the core is not thermally deformed.

The elastic core 10 may employ a conductive elastic core or a nonconductive elastic core. In the present invention, when the nonconductive elastic core is employed, the components of the present invention, including the metal layer and the conductive adhesive layer, are electrically conductive. When the conductive elastic core is employed, all the components of the present invention, including the metal layer, the conductive adhesive layer and the conductive elastic core, are electrically conductive. Accordingly, it is possible to further enhance the stability of the conductive contact terminal even upon repetitive expansion and contraction caused by external pressure.

Although the elastic core is not particularly limited as long as it has certain degrees of both elasticity and conductivity, it is preferred that the elastic core 10 be made of silicone.

The silicone elastic core 10 is formed by extrusion, rubber molding or hot pressing. Specifically, extrusion to a thickness of 4mm or more is more appropriate, and hot press molding to a thickness of 3mm or less is more appropriate. The conductive silicone elastic core is fabricated by imparting electrical conductivity to the silicone elastic core. Such impartation of electrical conductivity is accomplished by mixing electrically conductive metal powder with silicone. The mixing is carried out in a pressure kneader, which can realize efficient distribution characteristics in a short time period.

The compound of the silicone rubber and the electrically conductive metal powder, which were mixed in the pressure kneader, is formed into the conductive silicone elastic core 10 through the extrusion and the hot pressing.

In this compound, the mixing ratio of the electrically conductive metal powder is preferably 20 to 600 weight parts with respect to 100 weight parts of the silicone rubber. Available examples of the electrically conductive metal powder may include Ag, Au, Cu, Ni, Ni-Fe alloys, Sn, Ag-coated Cu or the like.

At a content of the conductive metal powder of 20 weight parts or more compared to 100 weight parts of the silicone rubber, it is difficult to realize desired electrical conductivity. At a content of the conductive metal powder of 600 weight parts or more, the amount of the conductive metal powder becomes excessive, such that the viscosity of the mixture increases, thereby making the forming difficult.

In addition, it is preferred that the size of the conductive metal powder range from 10µm to 70µm.

At a size of the metal powder of 10µm or less, there is the problem of low electrical conductivity since it becomes difficult for metal particles inside the silicone rubber to come into contact with each other. At a size of the metal powder of 70µm or more, there are problems caused by the size of particles during coating, such as scratches forming on the coated surface, difficulty in precise control over coating thickness, and a coarse outer surface.

It is appropriate that the hardness of the silicone rubber for the elastic core range from shore A 10° to shore A 70°. At a hardness of 10 or less, it becomes difficult for the molded product to keep its shape because the viscosity is too low. At a hardness of 70 or more, the forming becomes difficult because the viscosity is too high. The electrically conductive silicone elastic core, which was fabricated by mixing using the above-described method, has an electrical resistance that ranges from 0.1Ω to 10kΩ. The hardness and electrical resistance of the elastic rubber can be determined by suitably selecting the hardness of the silicone rubber and the mixing ratio depending on the intention.

The silicone elastic core that was formed through the above-described extrusion can be cured when it is left for about 0.5 to 5 minutes in a vertical curing machine, which stays at a temperature approximately in the range from 170°C to 350°C. The time for which the silicone elastic core is left therein can be adjusted depending on the temperature of the vertical curing machine.

A conductive adhesive 30 is applied on the silicone elastic core 10 that was fabricated by the above-described method, and a metal layer 20, i.e. another component of the present invention, including a metal coating layer 22 and a heat resistant film 21, is then bonded to the conductive adhesive 30, thereby producing the conductive contact terminal for surface mounting on a substrate according to the present invention.

Here, it is preferred that the conductive adhesive 30 contain an adhesive silicone component and a metal powder, which is intended to maintain electrical conductivity. The conductive adhesive 30 is very suitable for the bonding of a silicone material, and can be imparted with electrical conductivity by the metal compound that is contained therein. Examples of the metal powder include Ag, Au, Cu, Ni, Ni-Fe alloys, Sn, Ag-coated Cu, or the like. The conductive adhesive is dispensed onto the surface of the conductive silicone core by a dispenser, so that the conductive silicone elastic core is coated with the conductive adhesive to a regular thickness during its passage through a mold that has an interval approximately in the range from 0.01mm to 1mm from the contour thereof.

The cross-sectional shape of the elastic core 10 of the present invention may be a rectangle, a trapezoid, a pipe-like shape, or the like, but is not limited thereto. Rather, the elastic core 10 may have a variety of cross-sectional shapes as required. However, it is preferred that the underside of the contact terminal be planar such that it can be stably fixed to a circuit board.

A detailed description will be given below of another component of the present invention, i.e. the metal layer 20, which is formed on the elastic core 10. The types of the conductive metal layer are not specifically limited as long as they can be soldered. It is preferred that the conductive metal layer be made of a metal material, such as Cu, Ni, Au, Ag, Sn, or the like. Herein, the metal layer refers to a material that contains a metal component that is electrically conductive, and is used as a concept that includes a metal film, a metal mesh, and a film that is coated with a metal.

The metal layer 20 includes a base film 21 and metal coating layers 22. The metal coating layers 22 are made of a metal component, which is applied on the opposite surfaces of the film 21. As above, the metal layer 20 of the present invention is configured such that the metal component forms the coats on the opposite surfaces thereof. The metal component on the opposite surfaces forms first and second metal coating layers, which are formed on the opposite surfaces of the film layer. The film layer has a plurality of holes therein, and the first and second metal coating layers can be electrically connected to each other via the walls of the holes. Accordingly, the metal layer 20 of the present invention can be electrically connected to the conductive silicone elastic core 10 via the electrically conductive adhesive 30.

Considering that the product of the present invention must be subjected to reflow soldering in the SMT process, it is preferred that the film 21 employ a heat resistant film. Suitable examples of the film may be made of Polyimide (PI), Polyethylene naphthalate (PEN), Polyphenylene sulfide (PPS), or the like. In particular, the polyimide film is suitable to be used for a mobile phone, a digital camera, an LCD, a PDP TV, or the like, since it exhibits excellent heat resistance, can be freely flexed, and can be applied such that it has a thin profile. In addition, it is more preferred in terms of heat resistance that a fire retardant epoxy-based adhesive be applied on a fire retardant film. The fire retardant epoxy-based adhesive is solid, but can be uniformly applied on the fire retardant film. The fire retardant epoxy-based adhesive is bonded with another material in the state in which it is uniformly applied as a thin layer on the film, and cures when heat is applied thereto, so that it is fixed with another material. The conductive silicone elastic core is covered with the heat resistant film on which the epoxy adhesive is applied, is inserted into a mold, which has a shape similar to that of the core, and is then subjected to heat ranging from 160°C to 180°C. The epoxy is then cured, and thus the silicone elastic core and the heat resistant film are bonded to each other.

It is preferred that the heat resistant film have a plurality of holes, which are spaced apart from each other. The diameter of the holes ranges from 0.1mm to 0.5mm. The holes can be formed at regular intervals via an ultrasonic method, a laser method, or a punching method. When the heat resistant film having the holes, which are as machined above, are coated with a metal component, not only the opposite surfaces of the film but also the walls of the holes can be coated or filled with the metal component. The metal coating layer 22, which is formed in the holes as above, enables the heat resistant film to be electrically conductive.

In the present invention, the metal coating layer 22 can be formed as a thin metal coating layer on a heat resistance film using wet electrolytic plating. Here, the thickness of the metal coating layer 22 is desired to be µm to 20µm. When the metal film is too thin with a thickness less than 1µm, reflow soldering is not enabled. When the metal film is thicker than 20µm, there is a drawback in that the formability and the elasticity of the product are decreased without any particular improvement in conductivity.

In the present invention, it is preferred that a base deposition layer or metal base layer (also referred to as a 'lower plating layer'), which is made of Cu, Ni, Au, Ag, Sn, or the like, be further formed between the heat resistant film 21 and the metal coating layer 22. The metal base layer not only decreases the electrical conductivity of the metal coating layer 22, which forms the major component to conduct electricity, but also increases the bonding ability between the metal coating layer 22 and the heat resistant film 21. The metal base layer can be formed by deposition or wet electroless plating. Specific methods of forming the metal base layer are not particularly limited. The metal base layer formed on the heat resistant film 21 serves to stably fix the metal coating layer 22 to the film via wet plating, thereby preventing the metal coating layer 22 from being peeled off, which would otherwise cause electric conductivity to be lost.

In addition, there is an advantage since the metal coating layer is formed along the walls of the holes in the film to retain conductivity. That is, even in the event that lines are broken due to cracks in the metal layer caused by repeated compression, the electrical conductivity of the conductive silicone elastic core enables electrical conduction.

As described above, the metal layer 20 including the metal coating layer 22 and the heat resistant film 21 is put on and bonded to the surface of the conductive silicone elastic core 10 which is coated with the conductive adhesive 30. The metal layer 20 is cut according to the lengths of the outer surface area of the silicone elastic core, and is bonded to the silicone elastic core while passing through a mold. The silicone elastic core with the metal layer 20 bonded thereto cures while passing through an oven having a temperature ranging from 200°C to 300°C. The elastic core 10 to which the conductive metal layer 20 is bonded can be cut to predetermined sizes, thereby producing the conductive contact terminal 1 for surface mounting described above.

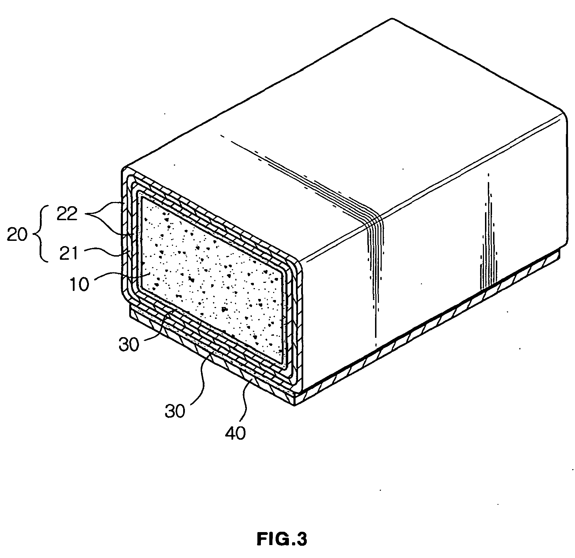

A metal film 40 may be bonded to one surface (e.g., the underside) of the conductive silicone elastic core 10, to which the conductive heat resistant film 20 is bonded, via the conductive adhesive 30, thereby producing the conductive contact terminal 1 for surface mounting shown in FIG. 3. The conductive contact terminal having the metal film attached thereto exhibits increased affinity to metal (Sn-plated Cu film) because of the metal film attached thereto, and thus its bonding ability is improved when soldered. It is preferred that the metal film have a thickness ranging from 50µm to 200µm. At a thickness of the metal film of 50µm or less, there is a problem in that wrinkles occur when bonded because the metal film is too thin. This makes it difficult to realize uniform soldering, thereby decreasing bonding force. In contrast, at a thickness of the metal film of 200µm or more, there are problems in that it is difficult to cut the terminal to predetermined intervals and in that fabrication costs increase.

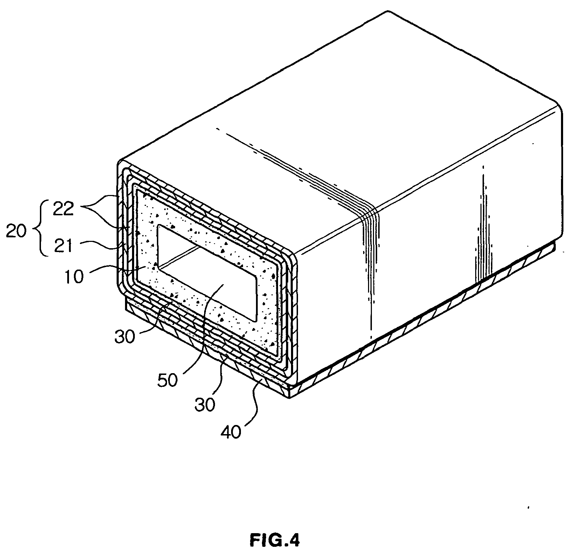

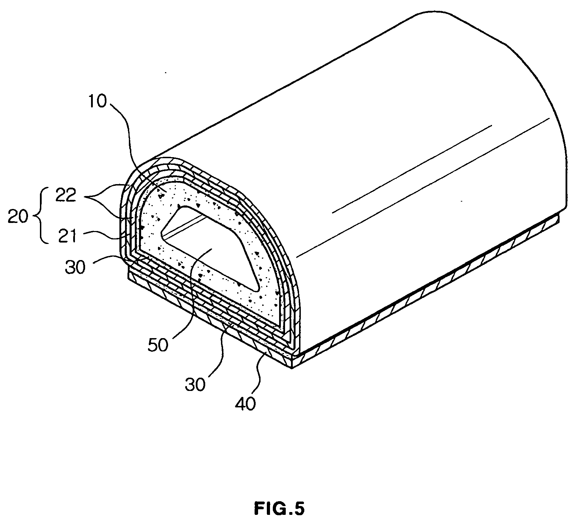

As shown in FIG. 4 and FIG. 5, the conductive elastic core 10 of the present invention may have a center hole 50, which extends in the lengthwise direction thereof. This center hole 10 can allow the elastic core 10 to be more easily compressed than that without the center hole, thereby increasing the elasticity of the conductive elastic core 10. In addition, it is possible to reduce the volume of the elastic core 10 as much as the volume of the center hole 50, thereby reducing overall fabrication costs. The center hole 50 may have a variety of shapes as desired. The formation of the center hole 50 into such a variety of shapes depends on the shapes of dies, which are used when extruding the silicone core. The shape and size of the center hole can be freely selected based on the variety of shapes of the dies.

Furthermore, the conductive contact terminal 1 for surface mounting on a substrate according to the present invention may have a variety of cross-sectional shapes depending on the variety of shapes of the conductive elastic core 10, and may have the shape shown in FIG. 5 as required.

Hereinafter, reference will be made in detail to examples of the present invention, so that a person having ordinary skill in the art to which the present invention relates can easily put the present invention into practice. The present invention may, however, be embodied in many different forms and should not be construed as limited to the examples set forth herein.

### [Mode for Invention]

### Example 1

200 weight parts of Ag-coated Cu powder having a particle size of 50µm (available from Chang-sung Co., ltd.) was mixed with 100 weight parts of silicone rubber having Shore hardness 30° (using a dispersion kneader, available from Fine Machinery), and the mixture was extruded at a rate of 2M/1min, and was cured at 250°C in a vertical curing machine, thereby forming a conductive silicone elastic core. The cured conductive silicone elastic core had an electrical resistance of about 10Ω.

A conductive silicone adhesive (which was prepared by mixing a silicone adhesive available from Dow Corning with metal powder at a mixing ratio of 1:2) was uniformly applied to a thickness of about 0.1mm on the conductive silicone elastic core, holes having a diameter of 0.2mm were formed in the resultant structure, a polyimide film (available from Sung-woo Co., Ltd.) was attached to the resultant structure to cover it, and then the resultant structure was cut to predetermined lengths, thereby producing a conductive contact terminal for surface mounting on a substrate.

### Example 2

The conductive silicone adhesive used in Example 1 was uniformly applied to a thickness of about 50µm on the underside of the silicone elastic core covered with the plated conductive polyimide film, which was used Example 1. A Cu film having a thickness of 200µm was attached to the resultant structure, and then the resultant structure was cut to predetermined lengths, thereby producing a conductive contact terminal for surface mounting on a substrate.

### Example 3 to Example 6

Conductive contact terminals for surface mounting on a substrate were fabricated in the same method as in Example 1 by replacing the silicone rubber having Shore hardness 30° of Example 1 with silicone rubbers having Shore hardness 40°, 50°, 60° and 70°. The conductive silicone adhesive used in Example 1 was uniformly applied to a thickness of about 50µm on the underside of the silicone elastic core covered with the plated conductive polyimide film, which was fabricated as above. A Cu film having a thickness of 200µm was attached to the resultant structure, and then the resultant structure was cut to predetermined lengths, thereby producing the conductive contact terminals for surface mounting on a substrate.

### Example 7

A conductive contact terminal for surface mounting on a substrate was fabricated in the same method as in Example 2 above, except that it used a nonconductive elastic core, which was entirely made of a silicone rubber having Shore hardness 60° and was nonconductive since Ag-coated Cu powder was not added. (See Table 1.)

**[Table 1]**

| Example | | 1 and 2 | 3 | 4 | 5 | 6 | 7 |
|---|---|---|---|---|---|---|---|
| Silicone hardness (Shore A) | | 30 | 40 | 50 | 60 | 70 | 60 |
| Compression test | 20% | Good | Good | Good | Good | Good | Good |
| | 30% | Good | Good | Good | Good | Good | Good |
| | 50% | Good | Good | Good | Good | Good | Good |
| Restoring force | After 50% compressed | 30 | 32 | 31 | 30 | 28 | 33 |
| | After 20% compressed | 37 | 39 | 38 | 36 | 32 | 38 |

When the conductive contact terminals for surface mounting on a substrate of Example 1 to Example 6 of the present invention, which were fabricated as above, were subjected to the compression test, they exhibited restoring forces as reported in Table 1. It can be appreciated that the restoring forces were 32% to 39% when compressed 20% and 28% to 32% when compressed 50%.

### Comparative Example

A conductive contact terminal for surface mounting on a substrate was fabricated in the same method as in Example 2 above, except that it used a nonconductive elastic core, which was entirely made of a silicone rubber having Shore hardness 65° and was nonconductive since Ag-coated Cu powder was not added, and used a nonconductive silicone adhesive, which was entirely composed of a silicone adhesive without metal powder.

### Experimental Example

Electrical resistances of the conductive contact terminals for surface mounting on a substrate, which were fabricated in foregoing Examples and Comparative Example, were measured.

The electrical resistances were measured based on the event that the metal layer is not broken and on the event that the metal layer is broken, and the results are reported in Table 2 below.

**[Table 2]**

| | Ex. 1 | Ex. 2 | Ex. 3 | Ex. 4 | Ex. 5 | Ex. 6 | Ex. 7 | Comp. Ex. |
|---|---|---|---|---|---|---|---|---|
| Typical electrical resistance (Ω) | 0.3 | 0.2 | 0.3 | 0.4 | 0.5 | 0.5 | 0.4 | 0.4 |
| Electrical resistance when broken (Ω) | 16 | 15 | 15 | 13 | 15 | 15 | 55 | Beyond measuring range |

As apparent from Table 2 above, the conductive contact terminals for surface mounting on a substrate according to Example 1 to Example 6 of the present invention substantially retained their electrical conductivity due to low electrical resistances even in the event that the outer metal layer was broken.

In particular, comparing the contact terminals of Example 1 to Example 6, which were fabricated using the electrically conductive elastic core, with the contact terminal of Example 7, which was fabricated using the electrically nonconductive elastic core, it can be appreciated that the contact terminal of Example 7 still retained electrical conductivity even though its electrical resistance increased to 55Ω in the event of breakage.

This result is because the contact terminal having the nonconductive elastic core of Example 7 used the electrically conductive adhesive to bond the elastic core and the conductive metal layer to each other. Therefore, it could be appreciated that, even in the event that the metal layer is broken, the adhesive layer made of the electrical conductive adhesive still imparted the contact terminal with electrical conductivity, and therefore the contact terminal still remained electrically conductive.

Unlike foregoing Examples, it could be appreciated that, when the outer metal layer was broken, the conductive contact terminal for surface mounting on a substrate of Comparative Example did not remain electrically conductive since its electrical resistance increased beyond the measuring range.

### [Industrial Applicability]

As set forth above, the present invention can provide a conductive contact terminal for surface mounting, which has a low electrical resistance, does not exhibit a deformation in the material even in a high-temperature reflow soldering process, and does not lose conductivity even though a metal layer, which imparts electrical conductivity to the conductive contact terminal, is broken.

## Claims

1. A conductive contact terminal for surface mounting comprising:
an elastic core (10), which imparts elasticity to the contact terminal;
a metal layer (20), which covers the outer portion of the elastic core; and
**characterised by**
a conductive adhesive layer (30), which is interposed between the elastic core and the metal layer to bond the elastic core and the metal layer to each other,
wherein the metal layer comprises:
a film layer (21); and first and second metal coating layers (22), each of the first and second metal coating layers being applied on a corresponding one of opposite surfaces of the film layer, wherein the film layer has a plurality of holes therein, and the first and second metal coating layers are electrically connected to each other through walls of the holes in the film layer.

2. The conductive contact terminal of claim 1, wherein the elastic core comprise a conductive elastic core.

3. The conductive contact terminal of claim 1 or 2, wherein the elastic core has a centre hole (50) in a central portion thereof.

4. The conductive contact terminal of claim 2, wherein the conductive elastic core (10) comprises 100 weight parts of elastic rubber and 20 to 600 weight parts of electrically conductive metal powder, which are mixed together.

5. The conductive contact terminal of claim 4, wherein the elastic rubber is one selected from the group consisting of bridged synthetic rubber, bridged natural rubber, and silicone rubber.

6. The conductive contact terminal of claim 4, wherein the electrically conductive metal powder is one selected from the group consisting of Ag, Au, Cu, Ni, Ni-Fe alloys, Sn and Ag-coated Cu.

7. The conductive contact terminal of claim 2, wherein the conductive elastic core has an electrical resistance ranging from 0.1Ω to 10kΩ.

8. The conductive contact terminal of claim 1, wherein the holes have a diameter ranging from 0.1 mm to 0.5 mm.

9. The conductive contact terminal of claim 1, wherein the metal component is selected from the group consisting of Cu, Ni, Au, Ag and Sn.

10. The conductive contact terminal of claim 1, wherein each of the first and second metal coating layers has a thickness ranging from 1µm to 20µm.

11. The conductive contact terminal of claim 1 or 2, wherein the conductive contact terminal being coupled at an underside thereof to a surface of a substrate, and further comprising a metal film attached to the underside via a conductive adhesive.

## Patentansprüche

1. Ein leitfähiger Kontaktanschluss für die Oberflächenmontage, umfassend:
einen elastischen Kern (10), der Elastizität des Kontaktanschlusses verleiht;
eine Metallschicht (20), die den äußeren Abschnitt des elastischen Kern bedeckt; und
gekennzeichnet mit
einer leitfähigen Haftschicht (30), die zwischen dem elastischen Kern und der Metallschicht angeordnet ist, um den elastischen Kern und die Metallschicht miteinander zu verbinden,
wobei die Metallschicht aufweist:
eine Filmschicht (21); und erste und zweite Metallbeschichtungsschichten (22), wobei jede der ersten und zweiten Metallbeschichtungsschichten auf einer entsprechenden der gegenüberliegenden Oberflächen der Folienschicht aufgebracht wird, worin die Filmschicht eine Vielzahl von Löchern darin aufweist, und die erste und die zweite Metallbeschichtungsschichten elektrisch miteinander durch Wände der Öffnungen in der Filmschicht verbunden sind.

2. Der leitfähige Kontaktanschluss nach Anspruch 1, wobei der elastische Kern (10) einen leitfähigen elastischen Kern umfasst.

3. Der leitfähige Kontaktanschluss nach Anspruch 1 oder 2 , wobei der elastische Kern ein zentrales Loch (50) in einem Mittelabschnitt davon umfasst.

4. Der leitfähige Kontaktanschluss nach Anspruch 2 , wobei der leitfähige elastische Kern 100 Gewichtsteile elastischen Gummi und 20 bis 600 Gewichtsteile eines elektrischen leitfähigen Metallpulver, die zusammengemischt sind, umfasst.

5. Der leitfähige Kontaktanschluss nach Anspruch 4, wobei der elastische Gummi ein, ausgewählt aus der Gruppe, die aus überbrücktem Synthesekautschuk, überbrücktem Naturkautschuk und Silikonkautschuk besteht, ist.

6. Der leitfähige Kontaktanschluss nach Anspruch 4, wobei das elektrische leitfähige Metallpulver ein, ausgewählt aus der Gruppe die aus Ag, Au, Cu, Ni, Ni-Fe-Legierungen, Sn und Ag-beschichtetem Cu besteht, ist.

7. Der leitfähige Kontaktanschluss nach Anspruch 2, wobei der leitfähige elastische Kern einen elektrischen Widerstand im Bereich von 0.1Ω bis 10kΩ weist.

8. Der leitfähige Kontaktanschluss nach Anspruch 1, wobei die Löcher einen Durchmesser im Bereich von 0,1 mm bis 0,5 mm haben.

9. Der leitfähige Kontaktanschluss nach Anspruch 1, wobei die Metallkomponente aus der Gruppe, die aus Cu, Ni, Au, Ag und Sn besteht, ausgewählt ist.

10. Der leitfähige Kontaktanschluss nach Anspruch 1, wobei jede der ersten und zweiten Metallbeschichtungsschichten eine Dicke im Bereich von 1 µm bis 20 µm hat.

11. Der leitfähige Kontaktanschluss nach Anspruch 1 oder 2, wobei der leitfähige Kontaktanschluss an seiner Unterseite mit einer Oberfläche eines Substrats verbunden ist, und ferner eine Matallschicht umfasst, die an der Unterseite mit einem leitfähigen Klebstoff befestigt ist.

## Revendications

1. Une borne de contact conductrice pour montage en surface comprenant :
un noyau élastique (10) qui confère de l'élasticité à la borne de contact ;
une couche de métal (20) qui couvre la portion externe du noyau élastique ; et
**caractérisée par**
une couche adhésive conductrice (30) qui est interposée entre le noyau élastique et la couche de métal pour adhérer le noyau élastique et la couche de métal l'une à l'autre,
dans laquelle la couche de métal comprend :
une couche laminaire (21) et des première et deuxième couches de revêtement métallique (22), chacune des première et deuxième couches de revêtement métallique étant appliquée sur l'une correspondante des surfaces opposées de la couche laminaire, dans laquelle la couche laminaire possède plusieurs trous et les première et deuxième couches de revêtement métallique sont connectées électriquement l'une à l'autre à travers des parois des trous dans la couche laminaire.

2. La borne de contact conductrice selon la revendication 1, dans laquelle le noyau élastique (10) comprend un noyau élastique conducteur.

3. La borne de contact conductrice selon la revendication 1 ou 2, dans laquelle le noyau élastique possède un trou central (50) dans une portion centrale.

4. La borne de contact conductrice selon la revendication 2, dans laquelle le noyau élastique conducteur (10) comprend 100 parts massiques de caoutchouc élastique et 20 à 600 parts massiques de poudre métallique à conduction électrique, qui sont mélangées ensemble.

5. La borne de contact conductrice selon la revendication 4, dans laquelle le caoutchouc élastique est l'un sélectionné parmi le groupe consistant du caoutchouc de synthèse ponté, du caoutchouc naturel ponté et du caoutchouc de silicone.

6. La borne de contact conductrice selon la revendication 4, dans laquelle la poudre métallique à conduction électrique est l'une sélectionnée parmi le groupe consistant de l'argent, l'or, le cuivre, le nickel, les alliages nickel-fer, le cuivre revêtu d'étain et d'argent.

7. La borne de contact conductrice selon la revendication 2, dans laquelle le noyau élastique conducteur possède une résistance électrique dans la gamme de 0.1 Ω à 10kΩ.

8. La borne de contact conductrice selon la revendication 1, dans laquelle les trous possèdent un diamètre dans la gamme de 0.1 millimètre à 0.5 millimètres.

9. La borne de contact conductrice selon la revendication 1, dans laquelle le matériau métallique est sélectionné parmi le groupe consistant du cuivre, du nickel, de l'or, de l'argent et de l'étain.

10. La borne de contact conductrice selon la revendication 1, dans laquelle chacune des première et deuxième couches de revêtement métallique possède une épaisseur dans la gamme de 1 micromètre à 20 micromètres.

11. La borne de contact conductrice selon la revendication 1 ou 2, dans laquelle une face inférieure de la borne de contact conductrice est couplée avec une surface d'un substrat et comprend en outre un film métallique attaché à la face inférieure au moyen d'un adhésif conducteur.
